# EUROPÄISCHE PATENTSCHRIFT

(11) **EP 0 629 114 B1**
(45) Veröffentlichungstag und Bekanntmachung des Hinweises auf die Patenterteilung: **20.11.1996**
(21) Anmeldenummer: 94250144.6
(22) Anmeldetag: 06.06.1994
(51) Int. Cl.: H05K 9/00

(54) **Verfahren zur Herstellung eines Gehäuses mit elektromagnetischer Abschirmung**
Method for manufacuring an electromagmetically shielded housing
Méthode de fabrication d'une boîte blindée contre des ondes électro-magnétiques

(30) Priorität: 14.06.1993 DE 4319965; 08.03.1994 DE 9404291 U
(43) Veröffentlichungstag der Anmeldung: 14.12.1994
(73) Patentinhaber: EMI-TEC, ELEKTRONISCHE MATERIALIEN GmbH, D-12277 Berlin (DE)
(72) Erfinder: Kahl, Helmut, Dipl.-Ing., D-12307 Berlin (DE); Tiburtius, Bernd, Dipl.-Ing., D-14532 Kleinmachnow (DE)
(74) Vertreter: Christiansen, Henning, Dipl.-Ing.

(56) Entgegenhaltungen:
- EP-A- 0 182 391
- EP-A- 0 241 192
- GB-A- 2 115 084

## Beschreibung

Die Erfindung betrifft ein Verfahren zur Herstellung eines Gehäuses mit elektromagnetischer Abschirmung nach dem Oberbegriff des Anspruchs 1 und ein Gehäuse nach dem Oberbegriff des Anspruchs 8.

Elektronische Bauelemente, aber auch gegenüber elektromagnetischer Strahlung störungsempfindliche Meß-, Untersuchungs- und ähnliche Anordnungen, benötigen zu ihrem störungsfreien Betrieb eine Abschirmung gegenüber den am Betriebsort vorhandenen elektromagnetischen Feldern.

Sie werden daher in abschirmenden Gehäusen untergebracht, die in den Wandungen leitfähiges Material aufweisen und im Sinne eines Faradayschen Käfigs wirken.

Solche Gehäuse finden darüber hinaus Anwendung für Geräte oder Baugruppen, die ihrerseits elektromagnetische Strahlung emittieren, die es von der Umgebung fernzuhalten gilt - sei es, um die Abstrahlung geheimzuhaltender Information oder Funktionsbeeinträchtigungen externer Geräte zu verhindern.

Derartige Schirmungen gegen die Ab- oder Einstrahlung von EMI müssen heute um so wirksamer sein, je mehr elektronische Geräte betrieben werden und je dichter diese Geräte im Betrieb beieinander angeordnet sein müssen. Schließlich erfordert auch der beständige Leistungs- und Empfindlichkeitszuwachs derartiger Geräte eine zusätzliche Verbesserung der Abschirmmaßnahmen. Hinzu kommt, daß hierfür immer weniger Raum zur Verfügung steht, da die betreffenden Geräte auch noch miniaturisiert sein sollen. Die sogenannte "elektromagnetische Verträglichkeit" bildet somit heutzutage neben ihren eigentlichen Funktionseigenschaften eine wesentliche qualitätsbestimmende Größe elektronischer Geräte.

Da es sich bei den Gehäusen meist um mehrteilige Konstruktionen handelt, bei denen zumindest ein gelegentliches Öffnen (etwa zur Erneuerung der Energiequelle oder zu Wartungszwecken) möglich sein muß, ist es zur Erreichung einer wirkungsvollen Abschirmung erforderlich, die beim Öffnen voneinander zu lösenden und beim Verschließen wieder miteinander in Kontakt zu bringenden Gehäuseteile mit elastischen leitfähigen Dichtungen zu versehen.

Dazu sind zum einen federartige metallische Abdichtungen bekannt, die jedoch konstruktiv vergleichsweise aufwendig sind und deren Funktionsfähigkeit durch Oxidation und Verschmutzung stark beeinträchtigt werden kann.

Weiterhin sind - etwa aus US 46 59 869 oder DE-OS 28 27 676 - flexible Dichtprofile aus leitfähigem oder leitend gemachtem Elastomermaterial bekannt, das zur Erzeugung der Leitfähigkeit mit Kohlenstoff- oder Metallpartikeln versetzt ist.

Derartige Dichtprofile werden üblicherweise als separate Dichtungen gefertigt - etwa formgepreßt oder als Endlosprofil extrudiert - und anschließend in das abzuschirmende Gehäuse eingelegt.

Dieses Vorgehen ist arbeitsaufwendig und stößt bei sehr kleinen Gehäusen auch insofern auf Schwierigkeiten, als Dichtungen mit entsprechend kleinen Abmessungen schwierig zu handhaben sind. Das Vorsehen geeigneter, die Anbringung am Gehäuse erleichternder Führungen (Nuten) erfordert unangemessen viel Platz und stellt damit ein Hindernis für die weitere Miniaturisierung der Geräte dar.

Kompliziert geformte Dichtungen, wie sie für spezielle Gehäuse erforderlich sein können, benötigen zum Einlegen spezielle Vorrichtungen, die die Fertigung der Gehäuse insgesamt verteuern. Außerdem ist das präzise Einlegen zeitaufwendig und erfordert zusätzliche Nachkontrollen.

Es ist auch bekannt, die in Rede stehenden Abschirmprofile heiß in Preßformen auf die entsprechenden Gehäuseabschnitte bzw. -teile aufzuformen und unter relativ hoher Temperatur und/oder hohem Druck auszuhärten.

Dieses Verfahren ist bei druck- und/oder temperaturempfindlichen Teilen, wie etwa Leiterplatten oder metallisierten Kunststoffgehäusen, nicht anwendbar und infolge der geringen Reißfestigkeit der verwandten Materialien mit Problemen beim Entformen und damit einer relativ hohen Ausschußquote und - insbesondere bei komplizierten Gehäuse- bzw. Dichtungsformen - auch vielfach mit der Notwendigkeit zeit- und kostenaufwendiger Nacharbeit an den Abpreßkanten verbunden.

Für das entsprechende Auftragen eines Dichtprofils per Siebdruck gibt die EP 0 241 192 A2 ein Beispiel.

Weitere Dichtungen sind aus DE-A-39 36 534 und DE-A-3 934 845 bekannt.

Der Erfindung liegt die Aufgabe zugrunde, bei einem Verfahren der eingangs genannten Gattung zur Erzeugung von Abschirmungen - insbesondere im Bereich von Trennfugen von voneinander lösbaren Gehäuseteilen - anzugeben, welches sich unterschiedlichsten Anforderungen auf einfache Weise - und auch bei miniaturisierter Bauweise - anpassen läßt. Insbesondere auch bei einfach und preiswert in größeren Stückzahlen herzustellenden Gehäusen soll das erfindungsgemäße Verfahren einsetzbar sein. Das nach diesem Verfahren hergestellte Gehäuse soll mit einem den elektromagnetischen und mechanischen Anforderungen genügenden Abschirmprofil versehen sein, welches auch noch nach wiederholtem Öffnen des Gehäuses eine gute Beständigkeit aufweist.

Diese Aufgabe wird durch ein Verfahren mit den Merkmalen des Anspruchs 1 bzw. durch ein Gehäuse mit den Merkmalen des Anspruchs 8 gelöst.

Die Erfindung schließt den Gedanken ein, das Abschirmprofil nicht separat, sondern in einem Schritt oder - insbesondere - mehreren Teilschritten direkt und ohne Preßform auf dem Gehäuse durch eine die erwünschten Eigenschaften aufweisende, sich unter Anhaften an der Gehäuseoberfläche verfestigende pastose Masse, die aus einer oder mehreren über den zu dichtenden Bereich geführte(n) Öffnung(en) austritt, zu erzeugen. Mit diesem Vorgehen werden die vorgefertigten Dichtprofilen anhaftenden Handhabungsprobleme und andererseits die verfahrensbedingten Nachteile des Formpressens vermieden, und es wird die Möglichkeit geschaffen, bedarfsweise Profile mit verschiedensten speziellen Querschnitten und/oder aus Teilabschnitten mit unterschiedlichen Materialeigenschaften (Grad der Elastizität, Leitfähigkeit, Thixotropie etc.) aufzubauen. Das Material besteht dabei aus einer Kunststoffmasse, die mindestens in Teilabschnitten leitende Einschlüsse - insbesondere in Form von Metallpartikeln oder als Kohlenstoffteilchen - enthält.

Wenn dabei die zur Bildung des Profils verwendete Nadel bzw. Düse maschinell, insbesondere rechnergesteuert, über den Abschnitt des Gehäuseteils, an dem das Abschirmprofil angeordnet sein soll, geführt wird, ist eine hohe Präzision und große Flexibilität bei der Formgebung des Profils gewährleistet, so daß auch kompliziert geformte Gehäuse bzw. Gehäuseöffnungen in kleinen Serien ohne weiteres wirtschaftlich mit der nötigen abschirmenden Abdichtung versehen werden können.

Die Erzeugung besonderer Profile - etwa auch mit Hinterschneidungen, Aussparungen etc. - am Gehäuse erfolgt vorteilhaft dadurch, daß zur Herstellung eines mehrschichtigen Abschirmprofils die (eine) Nadel bzw. Düse mehrfach oder mehrere Nadeln bzw. Düsen mindestens über vorbestimmte Bereiche des Abschnitts, an dem das Abschirmprofil angeordnet sein soll, geführt werden und dabei jeweils ein genau vorbestimmter Profilabschnitt gebildet wird. Der gewünschte Profilquerschnitt wird dabei in mehreren Arbeitsgängen nacheinander oder auch nahezu zeitgleich erzeugt. Die Profilgestalt wird vor allem über die geeignete Wahl der Anzahl, Querschnittsform und -größe und Abtastgeschwindigkeit der Nadel(n) bzw. Düse(n) und deren Lagebeziehung bei den einzelnen Auftragsschritten, daneben aber auch durch die Einstellung von Materialeigenschaften wie Viskosität, Thixotropie und Erhärtungs- bzw. Vernetzungsgeschwindigkeit, bestimmt.

Eine spezielle Verfahrengestaltung besteht darin, daß die mehreren Stränge elastischen sowie leitfähigen Materials in einer räumlichen Konfiguration und jeweils mit einem zeitlichen Abstand zueinander derart aufgetragen werden, daß ein teilweises Aushärten bzw. Vernetzen eines aufgebrachten Stranges erfolgt ist, wenn ein ihn berührender weiterer Strang aufgebracht wird.

Vorzugsweise lassen sich auf diese Weise auch Profilquerschnitte erzeugen, welche vorbestimmte Elastizitätseigenschaften aufweisen und diese Elastizität nicht aufgrund ihrer Kompressibilität, sondern aufgrund einer Biegeverformung erhalten, wie das bei gebogenen Lippenprofilen oder Hohlprofilen der Fall ist.

Insbesondere ist es auch nicht nötig, jeden Strang des Materials mit leitendenden Einschlüssen zu versehen, da auf Grund der Gesetze des elektromagnetischen Feldes auch linienförmige Leiter bereits eine große Abschirmwirkung aufweisen. Natürlich ist es von Vorteil, einen Strang aus hoch leitfähigem Material so vorzusehen, daß er die abzudichtenden Gehäuseteile beide auf möglichst großer Länge berührt. Die Dichtwirkung dieses leitfähigen Stranges ist von geringerer Bedeutung, da ihm ein oder mehrere Stränge aus weniger oder u.U. nicht leitfähigem, aber hoch elastischem Material zugeordnet werden können, die primär die Dichtfunktion des Profils übernehmen.

Mit den erfinderischen Maßnahmen lassen sich auch kompliziert geformte Dichtungen mit entlang ihrem Verlauf variierenden Abmessungen ohne besondere Schwierigkeiten erzeugen. Dabei kann sich der Querschnitt entlang der zu dichtenden Kante in weiten Grenzen entsprechend den jeweiligen Anforderungen verändern. Es lassen sich auch solche Formen von Abschirmprofilen erzeugen, welche derart zusammenhängen, daß sie in dieser Form einstückig nicht getrennt von dem Gehäuse hätten erzeugt und montiert werden können. Durch die erfindungsgemäßen Maßnahmen entfallen damit Trennfugen im Verlauf der abschirmenden Dichtung, so daß die Dichtwirkung an keiner Stelle unterbrochen ist.

Insbesondere kleinere Gehäusezonen oder -ergänzungen, welche nicht aus Metall bestehen oder nicht metallisiert sind - und damit eine Unterbrechung der geschlossenen Abschirmung - bilden würden, lassen sich in einem Arbeitsgang mit dem Erzeugen der übrigen Dichtung netzartig mit den erfindungsgemäßen Profilsträngen überziehen, so daß auch in solchen Bereichen homogene Abschirmverhältnisse vorhanden sind.

Auf diese Weise sind sogar netzartig in einer Ebene aufgespannte und an den Knotenpunkten des Netzes leitfähig verbundene Bahnen aus leitfähigem Kunststoff und damit aus der Dichtungsmasse selbst Elemente eines Faraday-Käfigs zu bilden.

Dadurch, daß beim mehrfachen Führen der Nadel bzw. Düse über die vorbestimmten Bereiche unterschiedliche elastische Materialien aufgebracht werden, wobei bei mindestens einem Auftrag leitfähiges Material aufgebracht wird, lassen sich Gehäuse mit vorteilhaft optimierten Leitfähigkeits-, Korrosions- und elastischen Eigenschaften der Dichtungen herstellen.

Gehäuse mit erleichterter Handhabung lassen sich insbesondere dadurch realisieren, daß das elastische leitfähige Material direkt auf den Kantenbereich einer verschließbaren Öffnung des Gehäuses rechnergesteuert derart aufgebracht wird, daß die Abschirmdichtung eine ein leichtes Öffnen und Schließen der Öffnung ermöglichende Konfiguration annimmt.

Zum Aufbringen der erfindungsgemäßen Abschirmprofile lassen sich solche computergesteuerten Handhabungsgeräte verwenden, welche eine dreidimensionale Führung der Nadel oder Düse zulassen, wobei eine vierte Größe die Dosierung des pastösen Materials in Abhängigkeit vom Vorschub betrifft. Mittels einer fünften Steuergröße kann dann auch noch eine Materialauswahl getroffen werden, d.h. es lassen sich verschiedene Materialstränge abwechselnd oder in "einem Arbeitsgang" gleichzeitig aufbringen, welche auch unterschiedliche zusammensetzung aufweisen können, so daß Materialeigenschaften des gesamten Profils im Querschnitt oder entlang seinem Verlauf ortsabhängig variieren. Diese ortsabhängigen Eigenschaften betreffen die Leitfähigkeit, die Elastizität (Biegsamkeit bzw. Kompressibilität) und/oder die Aushärtungseigenschaften des Materials.

Bei anderen vorteilhaften Ausführungen der Erfindung können statt Teilen des Gehäuses auch zur Außenoberfläche des Gerätes hinausragende Leiterplattenteile Abschirmfunktionen übernehmen und zur Anpassung an benachbarte Abschirmelemente die erfindungsgemäßen Maßnahmen vorgesehen sein.

Weitere vorteilhafte Weiterbildungen der Erfindung sind in den Unteransprüchen gekennzeichnet bzw. werden nachstehend zusammen mit der Beschreibung der bevorzugten Ausführungen der Erfindung anhand der Figuren näher dargestellt. Es zeigen:
Fig. 1a und 1b je eine Prinzipskizze zweier Ausführungsformen des erfindungsgemäßen Verfahrens,
Fig. 1c ein Detail von Fig. 1a,
Fign. 2a bis k schematische Teil-Querschnittsdarstellungen von Abschirmungsprofilen, die Bestandteil von Ausführungsformen des erfindungsgemäßen Gehäuses sind und in Ausführungsformen des erfindungsgemäßen Verfahrens hergestellt werden können, sowie
Fig. 3 eine schematische Darstellung des Verlaufs einer Gehäusekante mit Abschirmungsprofil eines erfindungsgemäßen Gehäuses in einer Ausführungsform.

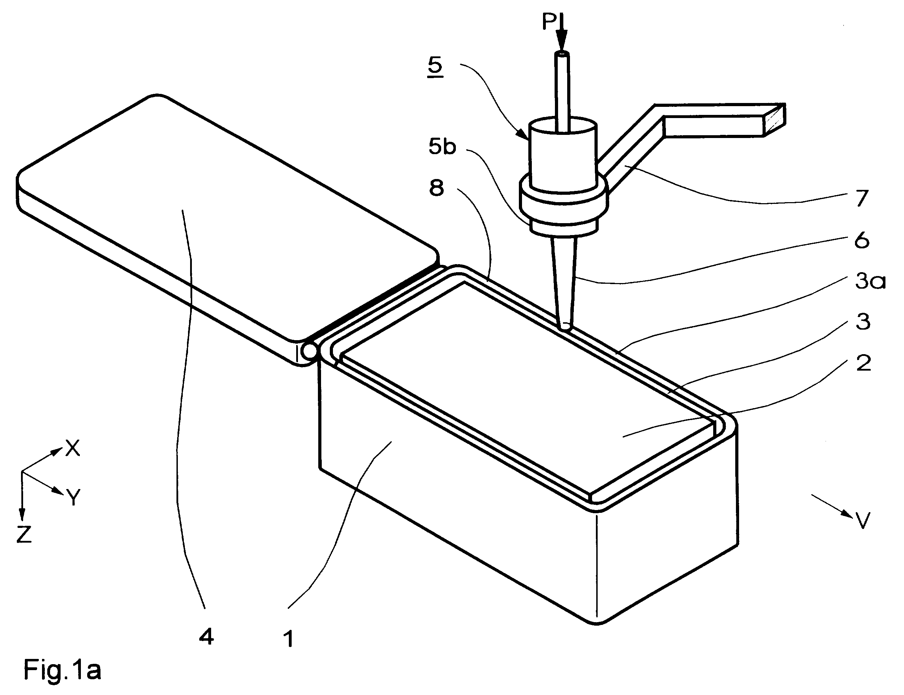

In Fig. 1a ist ein Aluminium-Abschirmgehäuse 1 für eine elektronische Schaltungsbaugruppe 2 dargestellt. das einen Gehäuseausschnitt 3 zum Einsetzen der Schaltungsbaugruppe aufweist, der nach deren Einsetzen mit einem Deckel 4 verschlossen wird.

Weiter ist in Fig. 1a ersichtlich, wie an den Kanten des Gehäuseausschnitts 3 über eine luftdicht mit einer Kolben-Zylinder-Vorrichtung 5 verbundene Auftragnadel 6, die zusammen mit der Kolben-Zylinder-Vorrichtung 5 durch einen rechnergesteuerten Roboterarm 7 unter Ausübung von Druck p auf den Kolben 5a der Vorrichtung 5 mit geringem und sehr genau eingehaltenem Abstand zum Gehäuse 1 mit der Geschwindigkeit v längs der umlaufenden Kante 3a geführt wird, ein Abschirmprofil 8 aufgebracht wird. Der Roboterarm ist in den drei Raumrichtungen x, y und z führbar.

Der Zylinder 5b der Vorrichtung 5 ist mit einer schnell luft- und raumtemperaturtrocknenden, Umgebungstemperatur aufweisenden Silikonwerkstoffmischung 8a mit eingelagerten Metallpartikeln gefüllt, die unter dem auf den Kolben 5a ausgeübten Druck durch die Kanüle 6a der Nadel 6 auf die Gehäuseoberfläche aufgedrückt ("dispensiert") wird, dort anhaftet und unter Luftzutritt zum elastischen Abschirmprofil 8 aushärtet.

Die (Querschnitts-)Abmessungen und Gestalt des Abschirmprofils 8 werden primär durch die physikochemischen Eigenschaften der verwendeten leitfähigen Kunststoffmasse - insbesondere deren Aushärtungsgeschwindigkeit, Viskosität, Oberflächenspannung bezüglich des Gehäusematerials und Thixotropie -, durch den Querschnitt der Kanüle, den auf den Kolben ausgeübten Druck, die Geschwindigkeit der Nadelbewegung sowie durch Umgebungseinflüsse wie Temperatur und Luftfeuchtigkeit am Herstellungsort - bestimmt und sind daher durch geeignete Wahl dieser Parameter vorgebbar.

Beim in Fig. 1a gezeigten Gehäuse 1 mit einem einseitig an einem Scharnier angebrachten Klappdeckel 4 kann es etwa vorteilhaft sein, die Auftragnadel 6 längs einem Kantenabschnitt der Öffnung 3 mit höherer Geschwindigkeit als in den anderen Abschnitten zu führen, womit dort in das Schließen des Deckels begünstigender Weise ein Profil mit geringerem Querschnitt als in den übrigen Kantenabschnitten gebildet würde. Die Einstellung der Eigenschaften der Kunststoffmasse kann dabei insbesondere durch Hinzufügung von Füllstoffen (Ruß o.ä.), Metallbindemitteln, Tensiden und Aushärtungsbeschleunigern bzw. Vernetzungswirkstoffen erfolgen. Auch die Art und Korngröße der die Leitfähigkeit sichernden Beimengung - etwa Kohlenstoff-, Silber, mit Silber oder Gold ummantelte Kupferpartikeln o.ä. - beeinflußt nicht nur die elektrischen, sondern auch die mechanischen und Verarbeitungseigenschaften des leitfähigen elastischen Materials.

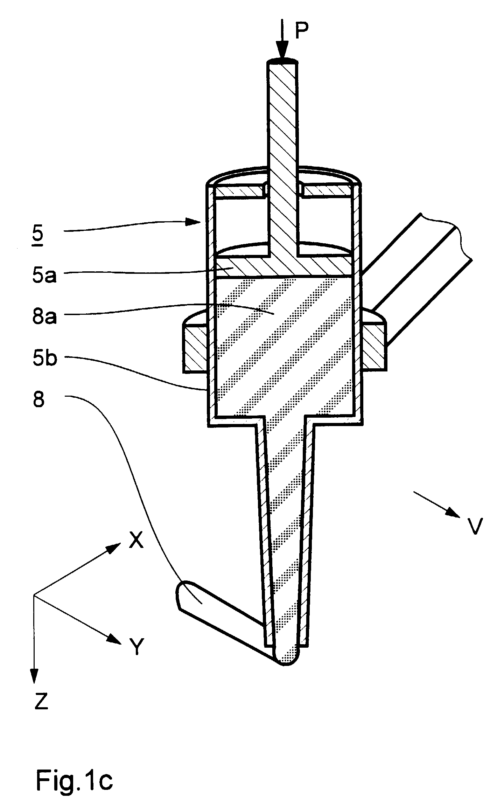

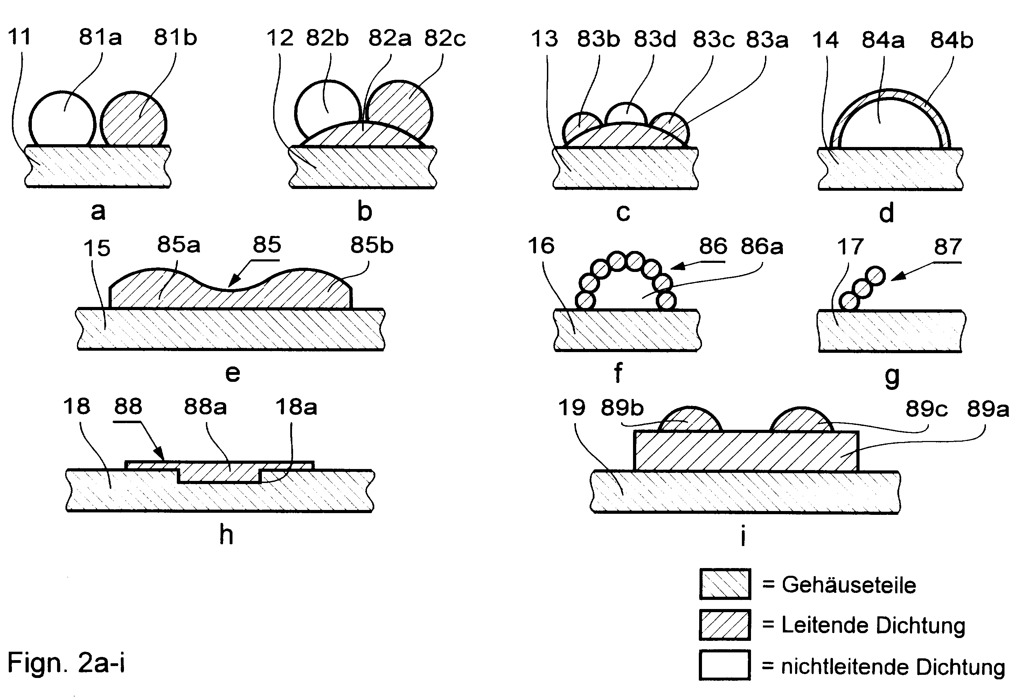

In Fig. 1c als Detail von Fig. la ist die Einheit 5 (mit im übrigen identischen Bezugszeichen) vergrößert wiedergegeben. Zusätzlich erkennbar sind ein Kolben 5a in einem Gehäuse 5b, welches einen Vorrat 8a der unverfestigten, später das Abschirmprofil 8 bildenden Masse beinhaltet.

Bei der Anordnung nach Fig. 1a kann der Roboterarm 7 mit der Auftragvorrichtung 5 mehrfach über den Kantenbereich der Öffnung 3 geführt werden, um mehrere Stränge des Silikonkautschuks übereinander und/oder nebeneinander oder in anderen (weiter unten beispielhaft näher dargestellten) Lagebeziehungen aufzubringen. Damit können Profilquerschnitte mit besonders vorteilhaften Dicht- und/oder Abschirmeigenschaften realisiert werden.

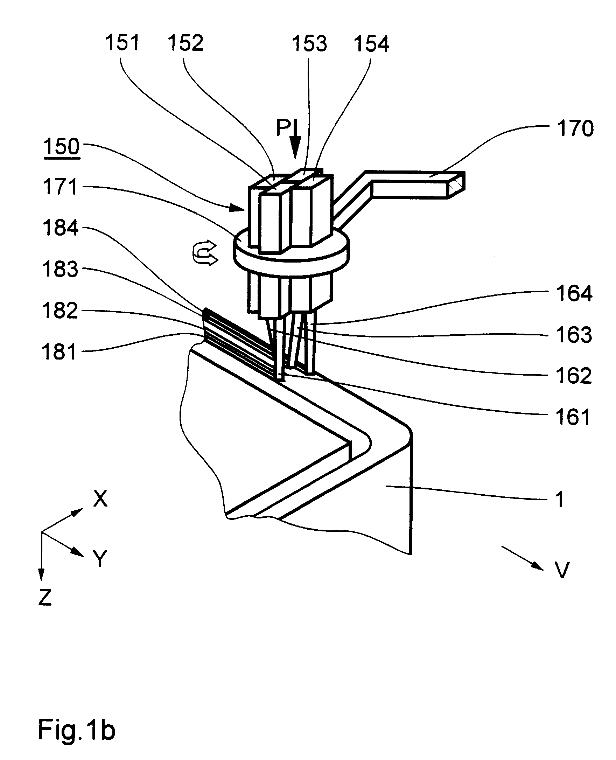

Alternativ dazu ist - wie in Fig. 1b gezeigt - der Einsatz einer Mehrdüsen-Auftragsvorrichtung möglich, mit der mehrere Materialstränge annähernd zeitgleich aufgebracht werden.

Die in Fig. 1b gezeigten Gehäuseteile entsprechen denen in Fig. 1a, so daß diese nicht nochmals beschrieben werden. Die Auftragvorrichtung 150 umfaßt vier Auftragmodule 151 bis 154, die jeweils eine Düse 161 bis 164 zum Ausstoßen eines Materialstranges und eine (hier nicht gesondert bezeichnete) Kolben-Zylinder-Vorrichtung ähnlich der der Auftragvorrichtung 5 in Fig. 1a aufweisen. Der modulare Aufbau der Vorrichtung ermöglicht die Zusammenstellung einer beliebigen Anzahl von Modulen, wahlweise auch mit einem Versatz gegeneinander, so daß die Auftragzeitpunkte der einzelnen Stränge etwas gegeneinander verschoben werden können. Da die Vorrichtung 150 zudem in einem Drehteller 171 im Roboterarm 170 gelagert ist, kann weiterhin die Lage damit aufgebrachter Materialstränge 181 bis 184 relativ zueinander und zur Gehäuseoberfläche über die Vorgabe der Winkelstellung des Drehtellers 171 variiert werden.

Die Module haben getrennte Materialbehälter und können unterschiedliche Düsenquerschnitte aufweisen, so daß Stränge aus verschiedenem Material und mit unterschiedlicher Gestalt miteinander kombininiert werden können.

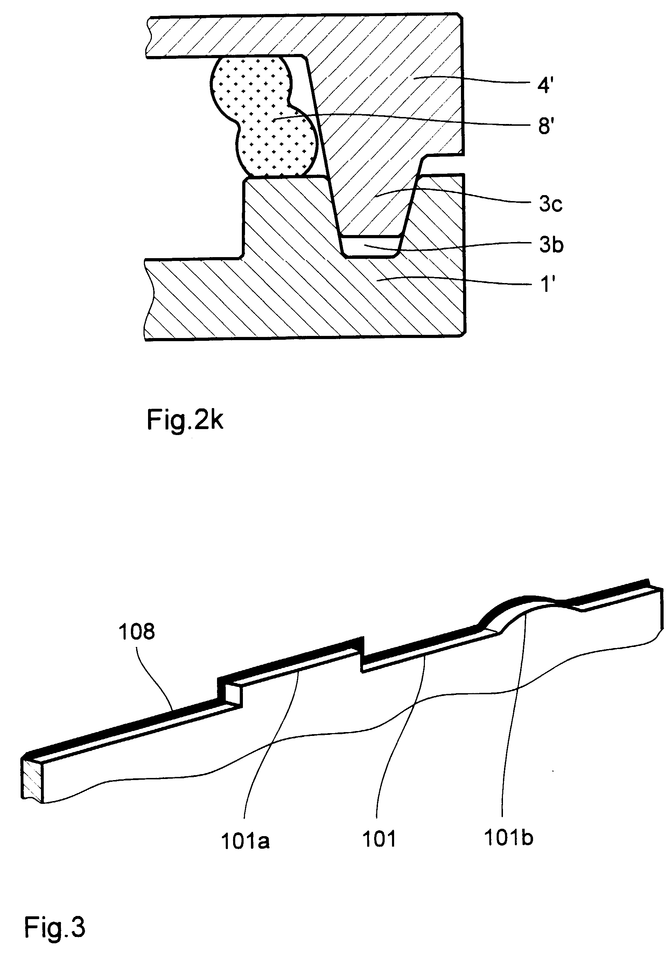

In den Fign. 2a bis k sind Beispiele unterschiedlicher Profilquerschnitte gezeigt, die mittels des erfindungsgemäßen Verfahrens bei Vorsehen mehrerer Auftrags-Schritte hergestellte Gehäuse aufweisen können. Es ist aber ersichtlich, daß mit den erfindungsgemäßen Maßnahmen die Querschnitte auch in Längsrichtung des Profils in ihren geometrischen Abmessungen und ihren Materialeigenschaften variieren können.

In den Fign. 2a bis 2d sind dabei leitende, weniger elastische Dichtungsteile (schraffiert dargestellt) mit nichtleitenden, aufgrund der fehlenden Metallbeimengung elastischeren Dichtungsteilen kombiniert, wodurch eine optimale Verbindung von Dicht- und Abschirmwirkung erreicht wird.

Fig. 2a zeigt insbesondere einen aus in zwei Auftragschritten nebeneinander auf der Oberfläche eines Gehäuseteils 11 aufgebrachten Profilen 81a und 81b mit annähernd kreisförmigem Querschnitt gebildeten Abschirmungs- und Dichtungsaufbau. Ein solcher Aufbau ergibt sich, wenn das elastische Material die Oberfläche des Gehäuses schwach benetzt.

Fig. 2b zeigt einen in drei Schritten erzeugten Profilaufbau aus einem flach gewölbten, breiten leitfähigen Profilteil 82a und einem auf dieses auf"dispensierten" leitfähigen Teil 82c und einem nicht leitfähigen Teil 82b auf einem Gehäuseabschnitt 12, wobei die Teile 82b und 82c annähernd kreisförmigen Querschnitt haben.

Ein solcher Aufbau ergibt sich, wenn das Material des ersten Profilteils 82a die Oberfläche des Gehäuses stark benetzt und/oder dessen Auftrag mit einer relativ breiten Düse anstelle der in Fig. 1 gezeigten Nadel 6 erfolgte, während das Material der Teile 82b und 82c geringe Benetzungsneigung gegenüber der Oberfläche des Teils 82a zeigt.

Fig. 2c zeigt einen zu Fig. 2b ähnlichen Aufbau, wobei allerdings beidseitig eines auf einem unteren, breiten Profilteil 83a auf einer Gehäuseoberfläche 13 zentral angeordneten hochelastischen, aber nicht leitfähigen, knapp halbkreisförmigen Dichtprofils 83d zwei ebenfalls annähernd halbkreisförmige, leitfähige Abschirm-Profilteile 83b und 83c angeordnet wurden.

Dieses letzere Profil zeigt große Stabilität gegenüber parallel zur Gehäuseoberfläche wirkenden Kräften, hat jedoch insgesamt eine vergleichsweise geringe Elastizität. Damit kann es etwa für Schiebeverschlüsse besonders geeignet sein.

Das Profil nach Fig. 2d hingegen, das aus einem halbkreisförmig auf eine Gehäuseoberfläche 14 aufgedrückten elastischen, nichtleitenden Profilteil 84a und einem dessen Oberfläche ummantelnden leitfähigen Überzug 84b besteht, weist hingegen ausgeprägt gute Elastizitätseigenschaften auf.

Seine Herstellung setzt hohes Benetzungsvermögen und gute Haftfähigkeit zwischen den Oberflächen der beiden Profilmaterialien voraus, und es eignet sich sehr gut für Klappverschlüsse, insbesondere, wenn Verschluß- und Gehäuseteile relativ viel Spiel gegeneinander haben oder selbst gewisse Elastizität aufweisen.

Die Fign. 2e bis 2i zeigen Abschirmprofile, die ausschließlich aus leitfähigem Material bestehen.

Fig. 2e zeigt ein speziell geformtes Profil 85 auf einer Gehäuseoberfläche 15, das zwei durch einen flachen Steg verbundene Wülste 85a und 85b aufweist. Es kann in der gezeigten oder ähnlicher Gestalt insbesondere aus zwei oder drei Einzelsträngen aufgebaut werden; im letzteren Fall kann der mittlere Strang insbesondere aus einem niedrigviskosen und/oder stark benetzenden Material gebildet werden, das relativ flach zwischen den beiden äußeren, vorher bereits angehärteten Strängen verläuft.

Ein solches Profil kann für Gehäuse mit kantenprofilierten Klappverschlüssen zweckmäßig sein.

Fig. 2f zeigt ein aus mehreren Profilsträngen mit Kreis-Querschnitt aus demselben, gut leitfähigen Material insgesamt halbkreisförmig aufgebautes Abschirmprofil 86 auf einer Gehäuseoberfläche 16, das mit dieser einen Luftraum 86a einschließt.

Das Zusammenwirken des Profils mit dieser "Luftkammer" sorgt für gute Elastizität des Gesamtprofils trotz vergleichsweise schlechter Elastizität seiner Bestandteile.

Fig. 2g zeigt ein lippenartiges, ebenfalls aus mehreren Strängen mit Kreis-Querschnitt unter jeweils einem seitlichen Versatz der Längsachsen aufgebautes Profil 87 auf einer Gehäuseoberfläche 17, das sich ebenfalls gut für Klappverschlüsse eignet.

In Fig. 2h ist ein T-förmiges Profil 88 auf einer eine rechteckige Nut 18a aufweisenden Gehäuseoberfläche 18 dargestellt, das mit einem breiten Mittelteil 88a in die Nut 18a eingreift und insgesamt eine plane, zur Gehäuseobefläche 18 außerhalb der Nut 18a parallele Oberfläche aufweist. Es kann gebildet werden , indem mit einem ersten, gut benetzenden Materialstrang (dem vorzugsweise bereits durch die Düsenöffnung ein der Nut entsprechender Querschnitt verliehen wurde) zunächst die Nut ausgefüllt wird und dann - bevor die Oberfläche des ersten Strangs vernetzt ist - ein zweiter, mittels einer noch breiteren Düsenöffnung ebenfalls bereits rechteckförmig vorgebildeter, Strang auf diesen ersten Strang aufgedrückt wird.

Dieses Abschirmprofil ist mit der Gehäuseoberfläche nicht nur stoff-, sondern auch formschlüssig verbunden, was seine Stabilität zusätzlich erhöht.

In Fig. 2i ist ein Profilaufbau aus einem annähernd rechteckigen Querschnitt aufweisenden Block 89a aus leitfähigem, elastischem Material und zwei darauf nebeneinander angeordneten, flach gewölbten Profilteilen 89b und 89c gezeigt, der durch seinen großen Querschnitt insbesondere zur Abschirmung gegenüber starken Feldern geeignet ist. aber durch die aufgesetzten Dichtlippen 89b und 89c auch ausreichende Elastizität aufweist.

Selbstverständlich sind - je nach Anwendungsfall - auch (nahezu beliebige) andere Querschnitte realisierbar.

Für bestimmte Anwendungen kann sich ausch eine Kombination aus vorgefertigten, eingelegten Dichtprofilen mit auf erfindungsgemäße Weise erzeugten Profilen als günstig erweisen.

In Fig. 2k ist ein weiteres Ausführungsbeispiel eines mit einer erfindungsgemäßen Dichtung versehenen Gehäuses im Bereich einer Stoßkante wiedergegeben. Das Gehäuse besteht aus einem Oberteil 4', welches mit einer umlaufenden Feder 3c versehen ist, welche in eine entsprechende umlaufende Nut 3b des Gehäuseunterteils 1' eingreift. Nut und Feder 3b bzw. 3c verjüngen sich, so daß ein relativ dichter Abschluß des Gehäuses gewährleistet ist, wobei der gegenseitige Abstand der Gehäuseteile jedoch aufgrund von Fertigungstoleranzen variieren kann. Das erfindungsgemäße Profilteil 8' sorgt nun für eine zusätzliche Abschirmung im Bereich der Kante, welche unabhängig von der relativen Position der beiden Gehäuseteile aufgrund ihrer Elastizität und der eingeschlossenen leitfähigen Materialien eine hochwertige Schirmung erzeugt. Durch die Neigung ihrer maximalen Querschnittserstreckung in Bezug auf die Richtung der Zusammenfügung der beiden Gehäuseteile wird die Elastizität sowohl durch die Kompressibilität als auch durch die Biegeverformbarkeit des Profilteils unterstützt. Auf diese Weise werden geringfügige möglicherweise bestehende Inhomogenitäten der Dichtigkeit der Abschirmung aufgrund der Gehäusepassungen sicher überbrückt und es läßt sich eine insgesamt hervorragende elektromagnetische Verträglichkeit erzielen.

In Fig. 3 ist schematisch die Längserstreckung eines Abschirmprofils 108 längs der Gehäusekante eines erfindungsgemäßen Gehäuses 101 mit einem beispielhaft rechteckförmigen Kantenvorsprung 101a und einer halbkreisförmigen Auswölbung 101b dargestellt. Mit dem erfindungsgemäßen Vrfahren kann jedwedem Verlauf eines gewünschten Dichtungsprofils gefolgt werden, so daß Abschirmungen hoher Qualität erzielbar sind.

Wenn in der vorangegangegen Beschreibung von Gehäusen und Gehäuseteilen gesprochen wurde, so werden unter diesen Begriff auch Bauteile gefaßt, die sowohl elektrische als auch mechanische Träger- bzw. Gehäuse-Funktionen haben - etwa eine Leiterplatte, die gleichzeitig als Gehäuseteil dient.

Auch netz- oder korbartige aufgebrachte Profile von Umhüllungen bei abzuschirmenden Einrichtungen oder deren Teilen sind in diesem Sinne von der vorgeschlagenen Lösung umfaßt.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch macht.

## Patentansprüche

1. Verfahren zur Herstellung eines Gehäuses mit elektromagnetischer Abschirmung (1,4), insbesondere zur Aufnahme elektronischer Funktionselemente (2), mit einem in einem vorbestimmten Abschnitt (3a) mindestens eines Gehäuseteils (1) angeordneten Abschirmprofil (8), das elastisches sowie leitfähiges Material aufweist, bei dem
das leitfähige Material (8') in einem pastösen Ausgangszustand derart mittels Druck aus einer Nadel (6) bzw. Düse direkt auf den Abschnitt (3a) des Gehäuseteils (1), an dem das Abschirmprofil (8) angeordnet sein soll, aufgebracht wird und sich dort unter Anhaften an dessen Oberfläche elastisch verfestigt, daß
die Profilgestalt über die geeignete Wahl der Querschnittsform und -größe und Abtastgeschwindigkeit der Nadel bzw. Düse sowie durch die Einstellung von Materialeigenschaften wie Viskosität, Thixotropie und Erhärtungs- bzw. Vernetzungsgeschwindigkeit, bestimmt wird.

2. Verfahren nach Anspruch 1, **dadurch gekennzeichnet**, daß die Nadel (6) bzw. Düse maschinell angetrieben, insbesondere rechnergesteuert, über den Abschnitt (3a) des Gehäuseteils (1), an dem das Abschirmprofil (8) angeordnet sein soll, geführt wird.

3. Verfahren nach Anspruch 1 oder 2, **dadurch gekennzeichnet**, daß die Nadel (6) bzw. Düse mehrfach oder mehrere Nadeln bzw. Düsen mindestens über vorbestimmte Bereiche des Abschnitts, an dem das Abschirmprofil angeordnet sein soll, derart geführt werden, daß sich aus mehreren Strängen elastischen sowie leitfähigen Materials ein Abschirm- und Dichtungsprofil mit im wesentlichen durch Anzahl, Austrittsquerschnitt, Abtastgeschwindigkeit und Lagebeziehung der Nadel(n) bzw. Düse(n) vorgegebenem Querschnitt aufbaut.

4. Verfahren nach Anspruch 3, **dadurch gekennzeichnet**, daß beim mehrfachen Führen der Nadel bzw. Düse bzw. beim Führen mehrerer Nadeln bzw. Düsen über die vorbestimmten Bereiche unterschiedliche elastische Materialien aufgebracht werden, wobei mindestens ein Strang hoch leitfähigen Materials derart aufgebracht wird, daß mittels dieses Stranges im geschlossenen Zustand des Gehäuses (1, 4) eine durchgehende leitende Verbindung zwischen dessen Teilen hergestellt wird.

5. Verfahren nach Anspruch 3 oder 4, **dadurch gekennzeichnet**, daß die mehreren Stränge elastischen sowie leitfähigen Materials in einer räumlichen Konfiguration und jeweils mit einem zeitlichen Abstand zueinander derart aufgetragen werden, daß ein teilweises Aushärten bzw. Vernetzen eines aufgebrachten Stranges erfolgt ist, wenn ein ihn berührender weiterer Strang aufgebracht wird.

6. Verfahren nach einem der Ansprüche 1 bis 5, **dadurch gekennzeichnet**, daß das elastische sowie leitfähige Material (8') direkt auf den Kantenbereich (3a) einer verschließbaren Öffnung (3) des Gehäuses (1, 4) rechnergesteuert derart aufgebracht wird, daß das Abschirmprofil (8) eine ein leichtes Öffnen und Schließen der Öffnung (3) ermöglichende Konfiguration annimmt.

7. Verfahren nach einem der Ansprüche 1 bis 6, **dadurch gekennzeichnet**, daß das Aufbringen des elastischen sowie leitfähigen Materials bei Raumtemperatur erfolgt.

8. Gehäuse (1, 4), hergestellt nach einem Verfahren nach einem der vorangehenden Ansprüche, insbesondere für elektronische Funktionselemente (2), das seinen Innenraum gegenüber elektromagnetischer Strahlung abschirmt, mit einem an einem vorbestimmten Abschnitt (3a) eines Gehäuseteils (1) angeordneten Abschirmprofil (8), das elastisches sowie leitfähiges Material aufweist,
**dadurch gekennzeichnet**,
daß das Abschirmprofil (8) direkt auf dem Abschnitt (3a) des Gehäuseteils (1) profilbildend festhaftend und pastös aufgebracht und auf diesem elastisch verfestigt ist, und
die Profilgestalt über die geeignete Wahl der Querschnittsform und -größe und Abtastgeschwindigkeit einer Nadel bzw. Düse sowie durch die Einstellung von Materialeigenschaften wie Viskosität, Thixotropie und Erhärtungs- bzw. Vernetzungsgeschwindigkeit, bestimmt ist.

9. Gehäuse (1,4) nach Anspruch 8, **dadurch gekennzeichnet**, daß das Abschirmprofil (8; 180) aus einem bei Raumtemperatur vernetzenden bzw. abbindenden Material gebildet ist.

10. Gehäuse nach Anspruch 8 oder 9, **dadurch gekennzeichnet**, daß das Abschirmprofil (180) mindestens bereichsweise aus mehreren, neben- und/oder übereinander angeordneten Materialsträngen aufgebaut ist, wobei jeder Strang (181 bis 184) an Ort und Stelle mit dem Gehäuseteil (1) und/oder einem anderen Strang festhaftend verbunden gebildet ist.

11. Gehäuse nach Anspruch 10, **dadurch gekennzeichnet**, daß das Abschirmprofil mindestens bereichsweise aus unterschiedlichen elastischen Materialien aufgebaut ist, wobei mindestens ein Materialstrang, der eine Verbindung zwischen den Teilen des Gehäuses bildet, leitfähiges Material aufweist.

12. Gehäuse (1,4) nach einem der Ansprüche 8 bis 11, **dadurch gekennzeichnet**, daß das Abschirmprofil (8, 180) im Kantenbereich (3a) einer verschließbaren Öffnung (3) des Gehäuses (1,4) angeordnet ist.

13. Gehäuse nach einem der Ansprüche 11 oder 12, **dadurch gekennzeichnet**, daß das Abschirmprofil einen Strang hoch elastischen, aber nicht oder wenig leitfähigen Materials und einen Strang wenig elastischen, aber hoch leitfähigen Materials aufweist.

14. Gehäuse nach einem der Ansprüche 8 bis 13, **dadurch gekennzeichnet**, daß das durch mehrere Materialstränge gebildete Profil (87) lippenförmig ist.

15. Gehäuse nach einem der Ansprüche 8 bis 14, **dadurch gekennzeichnet**, daß das durch mehrere Materialstränge gebildete Profil (86) ein Hohlprofil darstellt.

16. Gehäuse nach einem der Ansprüche 8 bis 15, **dadurch gekennzeichnet**, daß sich zwischen benachbarten Materialsträngen (83, 83c), welche leitende Einschlüsse enthalten, mindestens ein Profilstrang (83d) befindet, welcher solche Einschlüsse nicht enthält.

17. Gehäuse nach einem der Ansprüche 8 bis 16, **dadurch gekennzeichnet**, daß das leitfähige Elemente aufweisende Abschirmprofil das im übrigen im wesentlichen nichtleitende Gehäuse netzartig überzieht.

18. Gehäuse nach einem der Ansprüche 8 bis 16, **dadurch gekennzeichnet**, daß mindestens eine Leiterplatte in die abschirmende Außenform einbezogen ist.

19. Gehäuse nach einem der Ansprüche 8 bis 18, **dadurch gekennzeichnet**, daß benachbarte und/oder in Längsrichtung aneinander anschließende Materialstränge unterschiedliche Eigenschaften, insbesondere hinsichtlich Kompressibilität, Elastizität, Biegsamkeit, und/oder Härte aufweisen.

20. Gehäuse nach einem der Ansprüche 8 bis 19, **dadurch gekennzeichnet**, daß das Abschirmprofil (8') im wesentlichen parallel - insbesondere innenseitig parallel - zu Gehäusebereichen (1', 4') verläuft, welche nut- und federartig ineinandergreifen.

## Claims

1. Method for the production of a housing with electromagnetic screening (1,4), in particular to accommodate electronic functional elements (2), with a screening profile (8) which is arranged in a predetermined section (3a) of at least one housing part (1) and which has elastic and conductive material, wherein the conductive material (8') is applied in a pasty initial state from a needle (6) or nozzle by means of pressure, directly onto that section (3a) of the housing part (1) on which the screening profile (8) is to be arranged and sets there to an elastic condition, at the same time adhering to its surface, in such a way that the shape of the profile is determined by a suitable choice of cross-sectional form and size and the scanning rate of the needle or nozzle and by the adjustment of material properties such as viscosity, thixotropism and rate of curing or cross-linking.

2. Method according to claim 1, characterised in that the needle (6) or nozzle is guided over that section (3a) of the housing part (1) on which the screening profile (8) is to be arranged, being machine-driven, in particular under computer control.

3. Method according to claim 1 or 2, characterised in that the needle (6) or nozzle is guided in such a way several times or a plurality of needles or nozzles is guided in such a way at least over predetermined regions of the section on which the screening profile is to be arranged that a screening and sealing profile with a cross-section determined essentially by the number, outlet cross-section, scanning rate and positional relationship of the needle(s) or nozzle(s) is built up from a plurality of strands of elastic and conductive material.

4. Method according to claim 3, characterised in that different elastic materials are applied in the case where the needle or nozzle is guided several times over the predetermined regions or in the case where a plurality of needles or nozzles is guided over the predetermined regions, at least one strand of highly conductive material being applied in such a way that a continuous conductive connection between the parts of the housing (1,4) is established by means of this strand in the closed state of the said housing.

5. Method according to claim 3 or 4, characterised in that the plurality of strands of elastic and conductive material is applied in a spatial configuration and in each case at a time interval with respect to one another in such a way that partial curing or crosslinking of an applied strand has taken place when a further strand which touches it is applied.

6. Method according to one of claims 1 to 5, characterised in that the elastic and conductive material (8') is applied directly onto the edge region (3a) of a closable opening (3) of the housing (1,4) under computer control and in such a way that the screening profile (8) assumes a configuration which allows easy opening and closure of the opening (3).

7. Method according to one of claims 1 to 6, characterised in that the elastic and conductive material is applied at room temperature.

8. Housing (1,4), prepared by a process according to one of the preceding claims, in particular for electronic functional elements (2), which screens its interior from electromagnetic radiation, with a screening profile (8) which is arranged in a predetermined section (3a) of a housing part (1) and has elastic and conductive material, characterised in that the screening profile (8) is applied in a pasty, adhering form directly on the section (3a) of the housing part (1) to form a profile and is set resiliently thereon and the shape of the profile is determined by a suitable choice of cross-sectional form and size and the scanning rate of the needle or nozzle and by the adjustment of material properties such as viscosity, thixotropism and rate of curing or cross-linking.

9. Housing (1,4) according to claim 8, characterised in that the screening profile (8;180) is formed from a material which crosslinks or sets at room temperature.

10. Housing according to claim 8 or 9, characterised in that the screening profile (180) is built up, at least over certain areas, from a plurality of strands of material arranged next to one another and/or one above the other, each strand (181 to 184) being formed in situ and being joined in a firmly adhering manner to the housing part (1) and/or another strand.

11. Housing according to claim 10, characterised in that the screening profile is built up at least in certain areas from different elastic materials, at least one strand of material which forms a connection between the parts of the housing having conductive material.

12. Housing (1,4) according to one of claims 8 to 11, characterised in that the screening profile (8,180) is arranged in the edge region (3a) of a closable opening (3) of the housing (1,4).

13. Housing according to either of claims 11 or 12, characterised in that the screening profile has a strand of highly elastic but non-conductive or only slightly conductive material and a strand of highly conductive material with little elasticity.

14. Housing according to one of claims 8 to 13, characterised in that the profile (87) formed by a plurality of strands of material is lip-shaped.

15. Housing according to one of claims 8 to 14, characterised in that the profile (86) formed by a plurality of strands of material forms a hollow profile.

16. Housing according to one of claims 8 to 15, characterised in that between adjacent strands of material (83,83c) which contain conductive inclusions there is at least one profile strand (83d) which does not contain such inclusions.

17. Housing according to one of claims 8 to 16, characterised in that the screening profile having conductive elements covers the otherwise essentially nonconductive housing in the manner of a net.

18. Housing according to one of claims 8 to 16, characterised in that at least one printed circuit board is included in the screening external shape.

19. Housing according to one of claims 8 to 18, characterised in that adjacent strands of material and/or strands of material which adjoin one another in the longitudinal direction have different properties, especially as regards compressibility, elasticity, flexibility and/or hardness.

20. Housing according to one of claims 8 to 19, characterised in that the screening profile (8') runs essentially parallel - in particular parallel on the inside - to housing regions (1',4') which engage in one another tongue and groove fashion.

## Revendications

1. Procédé de fabrication d'un boîtier avec un blindage électromagnétique (1, 4), en particulier pour recevoir des éléments fonctionnels électroniques (2), avec un profilé de blindage (8) qui est disposé sur une portion prédéterminée (3a) d'au moins une partie (1) du boîtier et qui présente une matière élastique et conductrice, dans le cas duquel
on applique la matière conductrice (8'), à l'état initial pâteux, sous pression, depuis une aiguille (6) ou une buse, directement sur la portion (3a) de la partie (1) du boîtier sur laquelle doit être disposé le profilé de blindage (8) et elle s'y fixe élastiquement par adhérence à la surface du boîtier, de façon telle que
la forme du profilé se détermine en fonction du choix approprié de la forme et de la grandeur de la section et de la vitesse du balayage effectué par l'aiguille ou par la buse ainsi que par la prescription des caractéristiques de la matière comme viscosité, thixotropie et vitesse de durcissement ou de réticulation.

2. Procédé selon la revendication 1, caractérisé par le fait que l'aiguille (6) ou la buse est guidée, par entraînement mécanique, en particulier sous commande d'un ordinateur, le long de la portion (3a) de la partie (1) du boîtier dans laquelle doit être disposé le profilé de blindage (8).

3. Procédé selon la revendication 1 ou 2, caractérisé par le fait que l'aiguille (6) ou la buse passe plusieurs fois, ou que plusieurs aiguilles ou plusieurs buses passent au moins le long de zones prédéterminées de la portion sur laquelle le profilé de blindage doit être disposé, de façon que se construise un profilé de blindage et d'étanchéité constitué de plusieurs cordons d'une matière élastique et conductrice, et d'une section essentiellement prescrite par le nombre, la section de sortie, la vitesse de balayage et la relation de position de l'aiguille ou des aiguilles ou de la buse ou des buses.

4. Procédé selon la revendication 3, caractérisé par le fait que, si l'on fait passer plusieurs fois l'aiguille ou la buse ou si l'on fait passer plusieurs aiguilles ou plusieurs buses le long des zones prédéterminées, on applique des matières d'élasticité différente, étant précisé que l'on applique au moins un cordon de matière hautement conductrice de façon que grâce à ce cordon, à l'état fermé du boîtier (1, 4), soit réalisée une liaison conductrice continue entre ses parties.

5. Procédé selon la revendication 3 ou 4, caractérisé par le fait que l'on applique les cordons, qui sont plusieurs, de matière élastique et conductrice selon une configuration spatiale et avec un intervalle de temps entre chacun d'eux, de façon qu'il se fasse un durcissement, ou réticulation, partiel d'un cordon appliqué lorsque l'on applique un autre cordon en contact avec lui.

6. Procédé selon l'une des revendications 1 à 5, caractérisé par le fait que l'on applique directement, sous commande d'un ordinateur, la matière élastique et conductrice sur la zone de bordure d'une ouverture obturable du boîtier de façon que le profilé de blindage (8) prenne une configuration qui permette d'ouvrir et de fermer facilement l'ouverture.

7. Procédé selon l'une des revendications 1 à 6, caractérisé par le fait que l'application de la matière élastique et conductrice se fait à température ambiante.

8. Boîtier (1, 4) qui est fabriqué selon un procédé conforme à l'une des revendications précédentes, en particulier pour des éléments fonctionnels électroniques (2), et assure le blindage de son espace intérieur à l'égard d'un rayonnement électromagnétique, avec un profilé de blindage (8) qui est disposé sur une portion prédéterminée (3a) d'une partie (1) du boîtier et présente une matière élastique et conductrice,
caractérisé
par le fait que le profilé de blindage (8) est directement appliqué, à l'état pâteux et adhérent, en formant un profilé, sur la portion (3a) de la partie (1) du boîtier et s'y solidifie élastiquement et
que la forme du profilé est déterminée en fonction du choix approprié de la forme et de la grandeur de la section et de la vitesse de balayage d'une aiguille ou d'une buse ainsi que par la prescription des caractéristiques de la matière comme viscosité, thixotropie et vitesse de durcissement ou de réticulation.

9. Boîtier (1,4) selon la revendication 8, caractérisé par le fait que le profilé de blindage (8; 180) est formé d'une matière qui réticule ou fait prise à la température ambiante.

10. Boîtier selon la revendication 8 ou 9, caractérisé par le fait que le profilé de blindage (180) est constitué, au moins par zones, de plusieurs cordons de matière disposés l'un à côté de l'autre et/ou l'un au-dessus de l'autre, chaque cordon (181 à 184) étant formé sur place, relié par adhérence avec la partie (1) du boîtier et/ou avec un autre cordon.

11. Boîtier selon la revendication 10, caractérisé par le fait que le profilé de blindage est constitué, au moins par zones, de différentes matières élastiques, étant précisé qu'au moins un cordon de matière, qui forme une liaison entre les parties du boîtier, présente une matière conductrice.

12. Boîtier (1,4) selon l'une des revendications 8 à 11, caractérisé par le fait que le profilé de blindage (8, 180) est disposé dans la zone de bordure (3a) d'une ouverture obturable (3) du boîtier (1, 4).

13. Boîtier selon l'une des revendications 11 ou 12, caractérisé par le fait que le profilé de blindage présente un cordon de matière hautement élastique, mais non, ou peu, conductrice et un cordon de matière moins élastique, mais hautement conductrice.

14. Boîtier selon l'une des revendications 8 ou 13 caractérisé par le fait que le profilé (87) formé par plusieurs cordons de matière est en forme de lèvre.

15. Boîtier selon l'une des revendications 8 ou 14, caractérisé par le fait que le profilé (68) formé par plusieurs cordons de matière représente un profilé creux.

16. Boîtier selon l'une des revendications 8 ou 15, caractérisé par le fait qu'entre des cordons de matière voisins (83, 83c), qui contiennent des inclusions conductrices, se trouve au moins un cordon profilé (83d) qui ne contient pas de telles inclusions.

17. Boîtier selon l'une des revendications 8 ou 16, caractérisé par le fait que le profilé de blindage présentant des éléments conducteurs recouvre, à la façon d'un filet, le boîtier essentiellement non conducteur par ailleurs.

18. Boîtier selon l'une des revendications 8 ou 16, caractérisé par le fait qu'au moins une carte à circuit imprimé est contenue dans la forme extérieure à blinder.

19. Boîtier selon l'une des revendications 8 ou 18, caractérisé par le fait que des cordons de matière voisins et/ou se jouxtant l'un l'autre selon la direction longitudinale, présentent des caractéristiques différentes, en particulier au point de vue de la compressibilité, de l'élasticité, de l'aptitude au cintrage et/ou de la dureté.

20. Boîtier selon l'une des revendications 8 ou 19, caractérisé par le fait le profilé de blindage (8') est orienté sensiblement parallèlement - en particulier parallèlement du côté intérieur - à des zones (1', 4') du boîtier qui viennent en prise l'une dans l'autre par rainure et languette.
